(19) Europäisches Patentamt
European Patent Office
Office européen des brevets

(11) EP 4 733 779 A1

(12) EUROPEAN PATENT APPLICATION

(43) Date of publication:
29.04.2026 Bulletin 2026/18

(21) Application number: 25202353.6

(22) Date of filing: 16.09.2025

(51) International Patent Classification (IPC):
G01R 21/00 $^{(2006.01)}$    H02J 50/12 $^{(2016.01)}$
H05B 6/06 $^{(2006.01)}$    H05B 6/12 $^{(2006.01)}$

(52) Cooperative Patent Classification (CPC):
G01R 21/001; H02J 50/12; H05B 6/062

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 24.10.2024 CN 202411491144

(71) Applicant: Delta Electronics, Inc.
Taoyuan County 33341 (TW)

(72) Inventors:
• LIN, Chun-Wei
  33341 Taoyuan City (TW)
• HUANG, Ming-Shi
  33341 Taoyuan City (TW)
• HU, Jhih-Cheng
  33341 Taoyuan City (TW)
• CHEN, Yi-Min
  Taoyuan City (TW)

(74) Representative: 2K Patent Partnerschaft mbB
Hamburger Allee 26-28
60486 Frankfurt am Main (DE)

(54) **ELECTRONIC DEVICE AND METHOD TO ESTIMATE INPUT POWER INTO RESONANT TANK IN RESONANT CIRCUIT**

(57) An electronic device (100) to calculate input power ($P_r$) input to a resonant tank in a resonant circuit (102) includes a bandpass filter (108), a phase detection circuit (110), a peak detection circuit (112), and a processor (114). The bandpass filter receives a resonant current ($i_{rp}$) input to the resonant tank, and filters the resonant current to generate a first baseband current ($i_{rp,BPF}$). The phase detection circuit calculates a phase difference ($\theta_{v1-i1}$) between the first baseband current and a resonant tank voltage ($V_{rp}$) input to the resonant tank. The peak detection circuit generates a baseband current peak value ($I_{rp,PDC}$) according to the first baseband current. The processor performs a fast Fourier transform on the resonant tank voltage to obtain a resonant tank baseband voltage ($V_{rp1}$). The processor calculates the input power according to the resonant tank baseband voltage, the baseband current peak value, and the phase difference.

FIG. 1

**Description**

CROSS REFERENCE TO RELATED APPLICATIONS

This application claims the benefit of China Patent Application No. 202411491144.1, filed on October 24, 2024, the entirety of which is incorporated by reference herein.

BACKGROUND OF THE INVENTION

**Field of the Invention**

The present invention relates to an electronic device, and, in particular, it relates to an electronic device and a method to estimate input power into a resonant tank in a resonant circuit.

**Description of the Related Art**

Traditional power estimation technology uses high-speed sampling of a voltage signal and a current signal input to the resonant tank, multiplies and integrates the voltage signal and the current signal, and averages them to obtain input power. The above estimation process is complex and requires a microprocessor with high-order operations to execute.

BRIEF SUMMARY OF THE INVENTION

An embodiment of the present invention provides an electronic device. The electronic device includes a bandpass filter, a phase detection circuit, a peak detection circuit, and a processor. The bandpass filter receives a resonant current input to the resonant tank, and filters the resonant current to generate a first baseband current. The phase detection circuit is electrically connected to the bandpass filter, and calculates a phase difference between the first baseband current and the rising edges of a resonant tank voltage input to the resonant tank. The peak detection circuit is electrically connected to the bandpass filter, and generates a baseband current peak value according to the first baseband current. The processor performs a fast Fourier transform on the resonant tank voltage to obtain a resonant tank baseband voltage. The processor is electrically connected the phase detection circuit and the peak detection circuit, and calculates the input power according to the resonant tank baseband voltage, the baseband current peak value, and the phase difference.

According to the electronic device described above, the processor calculates the input power using the following equation: $P_r = \frac{11}{9\pi} V_{rp1} I_{rp,PDC} \cos(\theta_{v1} - \theta_{i1})$. $P_r$ is the input power, $V_{rp1}$ is the resonant tank baseband voltage, $I_{rp,PDC}$ is the baseband current peak value, and $\theta_{v1} - \theta_{i1}$ is the phase difference between the first baseband current and the rising edge of the resonant tank voltage.

The electronic device further includes a subtractor. The subtractor is electrically connected to the processor. The subtractor receives reference input power and the input power from the processor, and subtracts the reference input power and the input power to obtain the power difference.

The electronic device further includes a power regulator. The power regulator is electrically connected to the subtractor. The power regulator adjusts the input power according to the power difference to obtain the total input power.

The electronic device further includes a pulse frequency modulation circuit. The pulse frequency modulation circuit is electrically connected to the power regulator. The pulse frequency modulation circuit adjusts the frequency of a pulse signal according to the total input power, and outputs the pulse signal.

The electronic device further includes a gate driving circuit. The gate driving circuit is electrically connected to the pulse frequency modulation circuit. The gate driving circuit drives the resonant circuit according to the pulse signal.

According to the electronic device described above, the input power includes baseband power and maximum sideband power.

According to the electronic device described above, the resonant circuit is an inductor-inductor-capacitor (LLC) circuit, or a resonant circuit for wireless energy transmission, or a resonant circuit of an induction cooker.

An embodiment of the present invention provides a method to estimate input power input to a resonant tank in a resonant circuit. The method includes the following steps. A resonant current input to the resonant tank is received, and the resonant current is filtered to generate a first baseband current. A phase difference between the first baseband current and the rising edges of a resonant tank voltage input to the resonant tank is calculated. A baseband current peak value is generated according to the first baseband current. A fast Fourier transform is performed on the resonant tank voltage to obtain a resonant tank baseband voltage. The input power is calculated according to the resonant tank baseband voltage, the baseband current peak value, and the phase difference.

According to the method described above, the step of calculating the input power according to the resonant tank baseband voltage, the baseband current peak value, and the phase difference includes the following step. The input power is calculated using an equation.

The equation is $P_r = \frac{11}{9\pi} V_{rp1} I_{rp,PDC} \cos(\theta_{v1} - \theta_{i1})$. $P_r$ is the input power, $V_{rp1}$ is the resonant tank baseband voltage, $I_{rp,PDC}$ is the baseband current peak value, and $\theta_{v1} - \theta_{i1}$ is the phase difference between the first baseband current and the rising edge of the resonant tank voltage.

The method further includes the following steps. Reference input power is received, and the reference input power and the input power are subtracted to obtain the power difference. The input power is adjusted according to the power difference to obtain the total input power. The frequency of a pulse signal is adjusted according to the total input power, and the pulse signal is output. The resonant circuit is driven according to the pulse signal.

BRIEF DESCRIPTION OF THE DRAWINGS

The present invention can be more fully understood by reading the subsequent detailed description and examples with references made to the accompanying drawings, wherein:

FIG. 1 is a schematic diagram of an electronic device 100 in accordance with some embodiments of the present invention.

FIG. 2 is a waveform diagram of an input voltage $V_{in}(t)$, a resonant tank voltage $V_{rp}(t)$, and a resonant current $i_{rp}(t)$ in a resonant circuit 102 of FIG. 1 in accordance with some embodiments of the present invention.

FIG. 3A is a spectrum diagram of the resonant tank voltage $V_{rp}$ in the resonant circuit 102 of FIG. 1 based on a switching frequency $f_s$ in accordance with some embodiments of the present invention.

FIG. 3B is a spectrum diagram of the resonant tank voltage $V_{rp}$ in the resonant circuit 102 of FIG. 1 based on a mains frequency $f_{ac}$ in accordance with some embodiments of the present invention.

FIG. 3C is a spectrum diagram of the resonant tank voltage $V_{rp}$ in the resonant circuit 102 of FIG. 1 based on the switching frequency $f_s$ and the sideband frequency $f_s \pm k f_{ac}$ in accordance with some embodiments of the present invention.

FIG. 4A a spectrum diagram of the resonant current $i_{rp}$ in the resonant circuit 102 of FIG. 1 based on the switching frequency $f_s$ in accordance with some embodiments of the present invention.

FIG. 4B a spectrum diagram of the resonant current $i_{rp}$ in the resonant circuit 102 of FIG. 1 based on the mains frequency $f_{ac}$ in accordance with some embodiments of the present invention.

FIG. 4C a spectrum diagram of the resonant current $i_{rp}$ in the resonant circuit 102 of FIG. 1 based on the switching frequency $f_s$ and the sideband frequency $f_s \pm k f_{ac}$ in accordance with some embodiments of the present invention.

FIG. 5 is a diagram of a relationship between a resonant tank impedance $|Z_{pn}|$ and both the switching frequency $f_s$ and its harmonic frequency in the resonant circuit 102 of FIG. 1 in accordance with some embodiments of the present invention.

FIG. 6 is a waveform diagram of a first baseband current $i_{rp,BPF}(t)$, a low frequency current $i_{rp,PDC}(t)$, and a baseband current peak value $I_{rp,PDC}$ in the resonant circuit 102 of FIG. 1 in accordance with some embodiments of the present invention.

FIG. 7 is a waveform diagram of the resonant tank voltage $V_{rp}$, a baseband voltage $V_{rp,BPF}$, and the first baseband current $i_{rp,BPF}$ in the resonant circuit 102 of FIG. 1 in accordance with some embodiments of the present invention.

FIG. 8A is spectrum diagram of the input power $P_r$ calculated by a processor 114 based on the switching frequency $f_s$ in accordance with some embodiments of the present invention.

FIG. 8B is spectrum diagram of the input power $P_r$ calculated by the processor 114 based on the switching frequency $f_s$ and the sideband frequency $f_s \pm k f_{ac}$ in accordance with some embodiments of the present invention.

FIG. 9A is a schematic diagram of the resonant circuit 102 in FIG. 1 in accordance with some embodiments of the present invention.

FIG. 9B is a schematic diagram of the resonant circuit 102 in FIG. 1 in accordance with some embodiments of the present invention.

FIG. 10 is a flow chart of a method to estimate input power input to a resonant tank in a resonant circuit in accordance with some embodiments of the present invention.

DETAILED DESCRIPTION OF THE INVENTION

In order to make the above purposes, features, and advantages of some embodiments of the present invention more comprehensible, the following is a detailed description in conjunction with the accompanying drawing.

Certain terms are used throughout the description and following claims to refer to particular components. As one skilled in the art will understand, electronic equipment manufacturers may refer to a component by different names. This document does not intend to distinguish between components that differ in name but not function. It is understood that the words "comprise", "have" and "include" are used in an open-ended fashion, and thus should be interpreted to mean "include, but not limited to...". Thus, when the terms "comprise", "have" and/or "include" used in the present invention are used to indicate the existence of specific technical features, values, method steps, operations, units and/or components. However, it does not exclude the possibility that more technical features, numerical values, method steps, work processes, units, components, or any combination of the above can be added.

The directional terms used throughout the description and following claims, such as: "on", "up", "above", "down", "below", "front", "rear", "back", "left", "right", etc., are only directions referring to the drawings. Therefore, the directional terms are used for explaining and not used for limiting the present invention. Regarding the drawings, the drawings show the general characteristics of methods, structures, and/or materials used in specific embodiments. However, the drawings should not be construed as defining or limiting the scope or properties encompassed by these embodiments. For example, for clarity, the relative size, thickness, and position of each layer, each area, and/or each structure may be reduced or enlarged.

When the corresponding component such as layer or area is referred to as being "on another component", it may be directly on this other component, or other components may exist between them. On the other hand, when the component is referred to as being "directly on another component (or the variant thereof)", there is no component between them. Furthermore, when the corresponding component is referred to as being "on another component", the corresponding component and the other component have a disposition relationship along a top-view/vertical direction, the corresponding component may be below or above the other component, and the disposition relationship along the top-view/vertical direction is determined by the orientation of the device.

It should be understood that when a component or layer is referred to as being "connected to" another component or layer, it can be directly connected to this other component or layer, or intervening components or layers may be present. In contrast, when a component is referred to as being "directly connected to" another component or layer, there are no intervening components or layers present.

The electrical connection or coupling described in this disclosure may refer to direct connection or indirect connection. In the case of direct connection, the endpoints of the components on the two circuits are directly connected or connected to each other by a conductor line segment, while in the case of indirect connection, there are switches, diodes, capacitors, inductors, resistors, other suitable components, or a combination of the above components between the endpoints of the components on the two circuits, but the intermediate component is not limited thereto.

The words "first", "second", "third", "fourth", "fifth", and "sixth" are used to describe components. They are not used to indicate the priority order of or advance relationship, but only to distinguish components with the same name.

It should be noted that the technical features in different embodiments described in the following can be replaced, recombined, or mixed with one another to constitute another embodiment without departing from the spirit of the present invention.

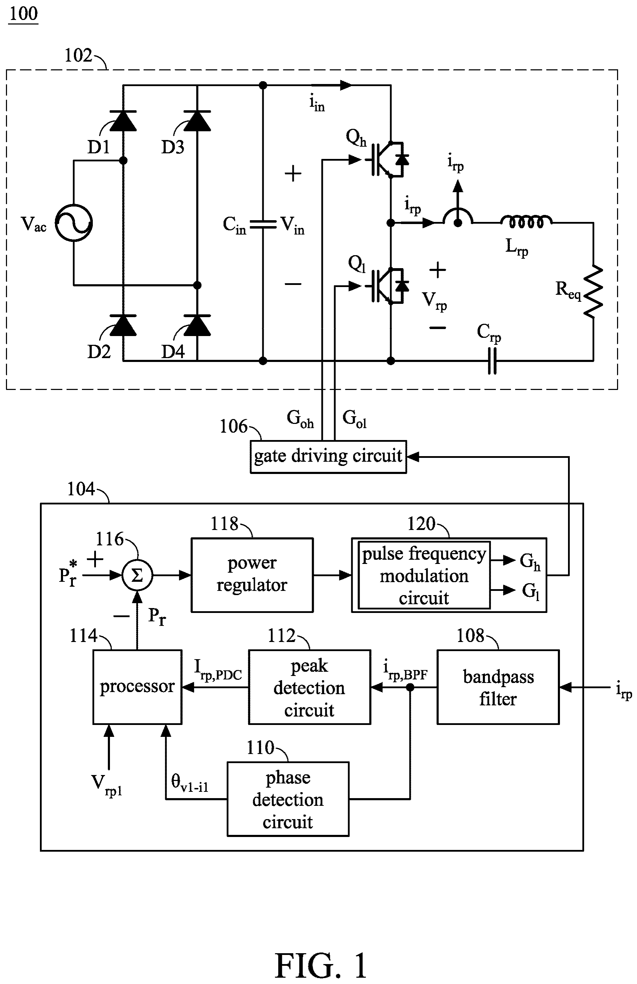

FIG. 1 is a schematic diagram of an electronic device 100 in accordance with some embodiments of the present invention. As shown in FIG. 1, the electronic device 100 includes a resonant circuit 102, a power control block circuit 104, and a gate driving circuit 106. In some embodiments, the resonant circuit 102 may be, for example, a part of circuits in an induction cooker, but the present invention is not limited thereto. The power control block circuit 104 calculates the input power $P_r$ input to a resonant tank in the resonant circuit 102. The frequency of the pulse signal $G_h$ or the pulse signal $G_l$ used to drive the resonant circuit 102 corresponds to the input power $P_r$. The power control block circuit 104 drives the resonant circuit 102 through the gate driving circuit 106. In some embodiments, the power control block circuit 104 includes a bandpass filter 108, a phase detection circuit 110, a peak detection circuit 112, a processor 114, a subtractor 116, a power regulator 118, and a pulse frequency modulation circuit 120.

The bandpass filter 108 receives a resonant current $i_{rp}$ input to the resonant tank in the resonant circuit 102, and filters the resonant current $i_{rp}$ to generate a first baseband current $i_{rp,BPF}$. The phase detection circuit 110 is electrically connected to the bandpass filter 108, and calculates a phase difference $\theta v_{1\text{-}i1}$ between the first baseband current $i_{rp,BPF}$ and a rising edge of a resonant tank voltage $V_{rp}$. The peak detection circuit 112 is electrically connected to the bandpass filter 108, and calculates a first baseband current $i_{rp,BPF}$ to generate a baseband current peak value $I_{rp,PDC}$. The processor 114 is electrically connected the phase detection circuit 110 and the peak detection circuit 112, and performs a fast Fourier transform on the resonant tank voltage $V_{rp}$ to obtain a resonant tank baseband voltage $V_{rp1}$. The processor 114 calculates the input power $P_r$ according to the resonant tank baseband voltage $V_{rp1}$, the baseband current peak value $I_{rp,PDC}$, and the phase difference $\theta_{v1\text{-}i1}$.

In detail, the processor 114 calculates the input power $P_r$ using the following equation 1.

$$P_r = \frac{11}{9\pi} V_{rp1} I_{rp,PDC} \cos(\theta_{v1} - \theta_{i1}) \dots \text{ equation 1.}$$

In equation 1, $P_r$ is the input power, $V_{rp1}$ is the resonant tank baseband voltage, $I_{rp,PDC}$ is the baseband current peak value, and $\theta_{v1} - \theta_{i1}$ is the phase difference between the first baseband current $i_{rp,BPF}$ and the rising edge of the resonant tank voltage $V_{rp}$.

The subtractor 116 is electrically connected to the processor 114, receives reference input power $P_r^*$ and the input power $P_r$ from the processor 114, and subtracts the reference input power $P_r^*$ and the input power $P_r$ to obtain the power difference. The power regulator 118 is electrically connected to the subtractor 116, and adjusts the input power $P_r$ according to the power difference to obtain the total input power. In some embodiments, the reference input power $P_r^*$ may be, for example, the target power set by the user, but the present invention is not limited thereto. For example, when the input power $P_r$ is less than the reference input power $P_r^*$, the power regulator 118 may correspondingly increase the power value of the input power $P_r$ to obtain the total input power. Moreover, when the input power $P_r$ is larger than the reference input power $P_r^*$, the power regulator 118 may reduce the power value of the input power $P_r$ to obtain the total input power.

The pulse frequency modulation circuit 120 is electrically connected to the power regulator 118, adjusts the frequency (for example, the switching frequency) of a pulse signal according to the total input power, and outputs the pulse signal. In some embodiments of FIG. 1, the pulse signal may be, for example, the pulse signal $G_h$ and the pulse signal $G_l$, but the present invention is not limited thereto. The gate driving circuit 106 is electrically connected to the pulse frequency modulation circuit 120, and outputs a driving signal $G_{oh}$ and a driving signal $G_{ol}$ according to the pulse signal $G_h$ and the pulse signal $G_l$ to drive the resonant circuit 102.

In some embodiments of FIG. 1, the resonant circuit 102 includes an AC power source $V_{ac}$, a diode $D_1$, a diode $D_2$, a diode $D_3$, a diode $D_4$, a capacitor $C_{in}$, a transistor $Q_h$, a transistor $Q_l$, an inductor $L_{rp}$, a capacitor $C_{rp}$, and a load resistor $R_{eq}$. One end of the AC power source $V_{ac}$ is electrically connected to the first end of the diode $D_1$ and the second end of the diode $D_2$. The other end of the power source $V_{ac}$ is electrically connected to first end of the diode $D_3$ and the second end of the diode $D_4$. The second end of the diode $D_1$ is electrically connected to the second end of the diode $D_3$. The first end of the diode $D_2$ is electrically connected to the first end of the diode $D_4$. The diode $D_1$, the diode $D_2$, the diode $D_3$, and the diode $D_4$ use the physics feature that signals can only pass from their first end to their second end, but cannot pass from their second end to their first end, to perform a rectification operation on the signal output by the AC power source $V_{ac}$ to obtain the input current $i_{in}$ and the input voltage $v_{in}$ generated across the capacitor $C_{in}$. Both ends of the capacitor $C_{in}$ are connected across the second end of the diode $D_3$ and the first end of the diode $D_4$ respectively.

The control end of the transistor $Q_h$ receives the driving signal $G_{oh}$ from the gate driving circuit 106. The first end of the transistor $Q_h$ is electrically connected to the second end of the diode $D_3$. The second end of the transistor $Q_h$ is electrically connected to the first end of the transistor $Q_l$. The control end of the transistor $Q_l$ receives the driving signal $G_{ol}$ from the gate driving circuit 106. The first end of the transistor $Q_l$ is electrically connected to the inductor $L_{rp}$. The second end of the transistor $Q_l$ is electrically connected to the first end of the diode $D_4$ and the capacitor $C_{rp}$. The resonant tank of the resonant circuit 102 includes the inductor $L_{rp}$, the capacitor $C_{rp}$, and the load resistor $R_{eq}$, but the present invention is not limited thereto. The voltage across the first end and the second end of the transistor $Q_l$ is equal to the resonant tank voltage $V_{rp}$. The current flowing from the second end of the transistor $Q_h$ to the inductor $L_{rp}$ is equal to the resonant current $i_{rp}$.

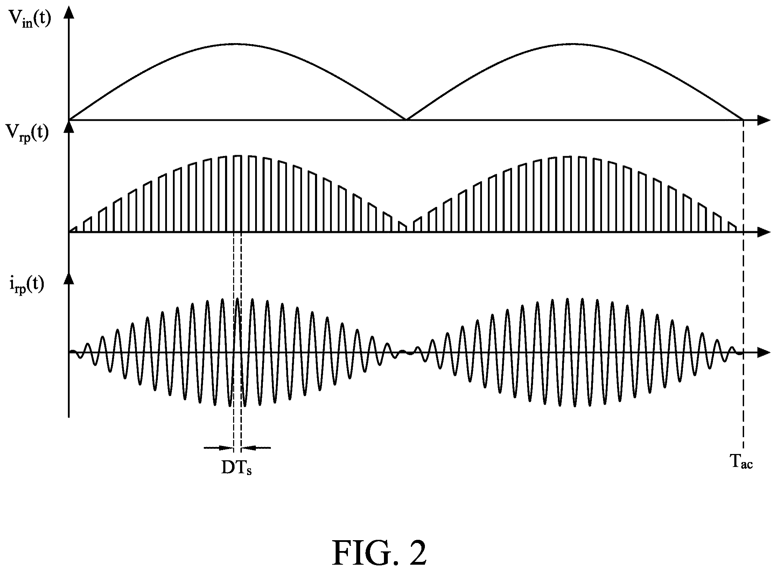

FIG. 2 is a waveform diagram of an input voltage $V_{in}(t)$, a resonant tank voltage $V_{rp}(t)$, and a resonant current $i_{rp}(t)$ in a resonant circuit 102 of FIG. 1 in accordance with some embodiments of the present invention. As shown in FIG. 2, in an AC period $T_{ac}$, due to the rectification by the diode $D_1$, the diode $D_2$, the diode $D_3$, and the diode $D_4$, the input voltage $V_{in}(t)$ has a positive waveform with two peaks. In some embodiments, the AC period $T_{ac}$ is the reciprocal of the frequency $f_{ac}$ of the AC power source $V_{ac}$, which may be, for example, the reciprocal of the mains frequency 60Hz. The transistor $Q_h$ and the transistor $Q_l$ load the frequency information of the driving signal $G_{oh}$ and the driving signal $G_{ol}$ into the waveform of the input voltage $V_{in}(t)$, thereby generating the waveform of the resonant tank voltage $V_{rp}(t)$. In some embodiments, the resonant tank voltage $V_{rp}(t)$ can be expressed by the following equation 2 after Fourier series expansion.

$$V_{rp}(t) = V_c + \sum_{k=even}^{\infty} v_{rp,k}(t) + \sum_{n=odd}^{\infty} [v_{rpn}(t) + v_{rpn,sbk}(t)] \dots \text{ equation 2.}$$

In equation 2,

$$V_c = \frac{2DV_p}{\pi} \ \text{(equation 3)}$$

is provided. $V_p$ is the peak value of the sine wave voltage of the AC power source $V_{ac}$, and D is the ratio of the time for the upper arm switch (for example, the transistor $Q_h$) closing to the switching period $T_s$.

In equation 2,

$$v_{rp,k}(t) = \frac{-4DV_p}{\pi(k^2-1)} \cos(2k\pi f_{ac} t) \ \text{(equation 4)}$$

is provided. $V_p$ is the peak value of the sine wave voltage of the AC power source $V_{ac}$, D is the ratio of the time for the upper arm switch (for example, the transistor $Q_h$) closing to the switching period $T_s$, and $f_{ac}$ is the frequency of the AC power source $V_{ac}$.

In equation 2,

$$v_{rpn}(t) = \frac{2\sqrt{2}V_p}{n\pi^2} \sqrt{1 - \cos(2nD\pi)} \sin(2n\pi f_s t + \theta_{vn}) \ \text{(equation 5)}$$

is provided. $V_p$ is the peak value of the sine wave voltage of the AC power source $V_{ac}$, n is the n times harmonic of the switching frequency (n is an odd number), D is the ratio of the time for the upper arm switch (for example, the transistor $Q_h$) closing to the switching period $T_s$, and $f_s$ is the switching frequency of the switches (for example, the transistor $Q_h$ and the transistor $Q_l$). $\theta_{vn}$ is shown in the following equation 7.

In equation 2,

$$v_{rpn,sbk}(t) = \frac{-2\sqrt{2}V_p}{n\pi^2} \sqrt{1 - \cos(2nD\pi)} \sum_{k=even}^{\infty} \left( \frac{\sin[(nf_s \pm kf_{ac})2\pi t + \theta_{vn}]}{k^2-1} \right)$$

is provided. $V_p$ is the peak value of the sine wave voltage of the AC power source $V_{ac}$, n is the n times harmonic of the switching frequency (n is an odd number), D is the ratio of the time for the upper arm switch (for example, the transistor $Q_h$) closing to the switching period $T_s$, $f_s$ is the switching frequency of the switches (for example, the transistor $Q_h$ and the transistor $Q_l$), and $f_{ac}$ is the frequency of the AC power source $V_{ac}$. $\theta_{vn}$ is shown in the following equation 7.

In equations 5 and 6,

$$\theta_{vn} = \tan^{-1}\left(\frac{\sin(2nD\pi)}{1-\cos(2nD\pi)}\right) \ \text{(equation 7)}$$

is provided. n is the n times harmonic of the switching frequency (n is an odd number), and D is the ratio of the time for the upper arm switch (for example, the transistor $Q_h$) closing to the switching period $T_s$.

As shown in the above equations 2 to 7, the resonant tank voltage $V_{rp}$ includes the signal component of the frequency $f_{ac}$ in the AC power source $V_{ac}$ and the signal component with its harmonic frequency ($k \cdot f_{ac}$), plus the signal component of the highfrequency switching frequency $f_s$ and the signal component with its harmonic frequency ($n \cdot f_s$) and its sideband frequency ($nf_s \pm kf_{ac}$).

Similarly, in some embodiments of FIG. 2, the resonant current $i_{rp}(t)$ also carries the information of the period $DT_s$, which is the same as the resonant tank voltage $V_{rp}(t)$ carrying the information of the period $DT_s$. D is the ratio of the time for the upper arm switch (for example, the transistor $Q_h$) closing to the switching period $T_s$.

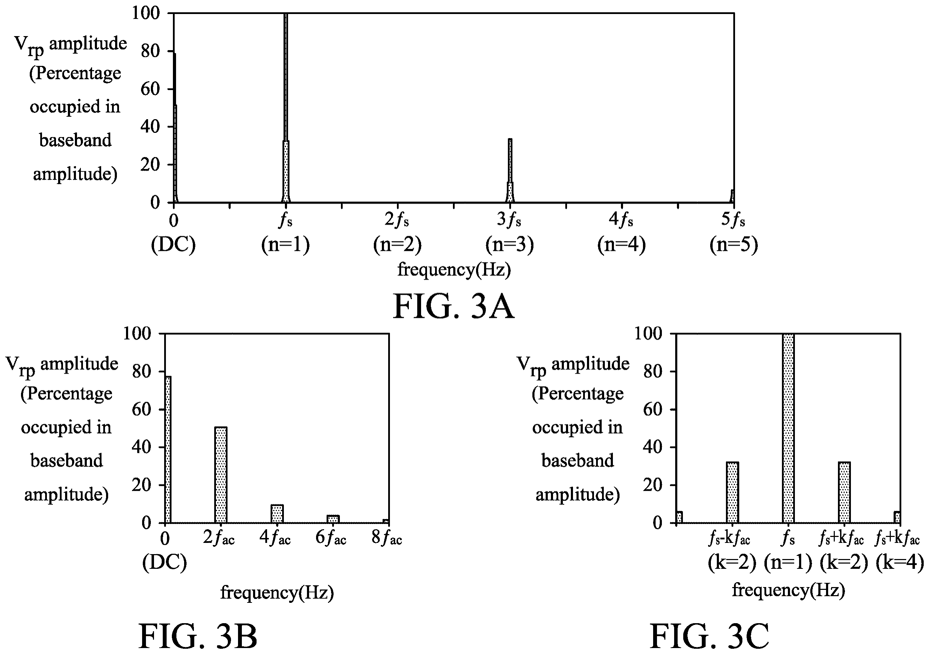

FIG. 3A is a spectrum diagram of the resonant tank voltage $V_{rp}$ in the resonant circuit 102 of FIG. 1 based on a switching frequency $f_s$ in accordance with some embodiments of the present invention. As shown in FIG. 3A, the resonant tank voltage $V_{rp}$ has the maximal amplitude at the switching frequency $f_s$ (that is, its resonant frequency, n=1). The resonant tank voltage $V_{rp}$ has the sub-maximal amplitude at frequency 0 (for example, the DC). The resonant tank voltage $V_{rp}$ has the sub-minimal amplitude at 3 times the switching frequency $3f_s$ (n=3). The resonant tank voltage $V_{rp}$ has the minimal amplitude at 5 times the switching frequency $5 f_s$ (n=5).

FIG. 3B is a spectrum diagram of the resonant tank voltage $V_{rp}$ in the resonant circuit 102 of FIG. 1 based on a mains frequency $f_{ac}$ in accordance with some embodiments of the present invention. As shown in FIG. 3B, the resonant tank voltage $V_{rp}$ has the maximal amplitude at frequency 0 (for example, the DC). The resonant tank voltage $V_{rp}$ has the sub-maximal amplitude at 2 times the mains frequency $2f_{ac}$ of the AC power source $V_{ac}$. The resonant tank voltage $V_{rp}$ has the third-maximal amplitude at 4 times the mains frequency $4f_{ac}$. The resonant tank voltage $V_{rp}$ has the sub-minimal amplitude at 6 times the mains frequency $6f_{ac}$. The resonant tank voltage $V_{rp}$ has the minimal amplitude at 8 times the mains frequency $8f_{ac}$.

FIG. 3C is a spectrum diagram of the resonant tank voltage $V_{rp}$ in the resonant circuit 102 of FIG. 1 based on the

switching frequency $f_s$ and the sideband frequency $f_s \pm kf_{ac}$ in accordance with some embodiments of the present invention. As shown in FIG. 3C, the resonant tank voltage $V_{rp}$ has the maximal amplitude at the switching frequency $f_s$ (n=1). The resonant tank voltage $V_{rp}$ has the same amplitude at the frequency $(n \cdot f_s + k \cdot f_{ac})$ and the frequency $(n \cdot f_s - k \cdot f_{ac})$.

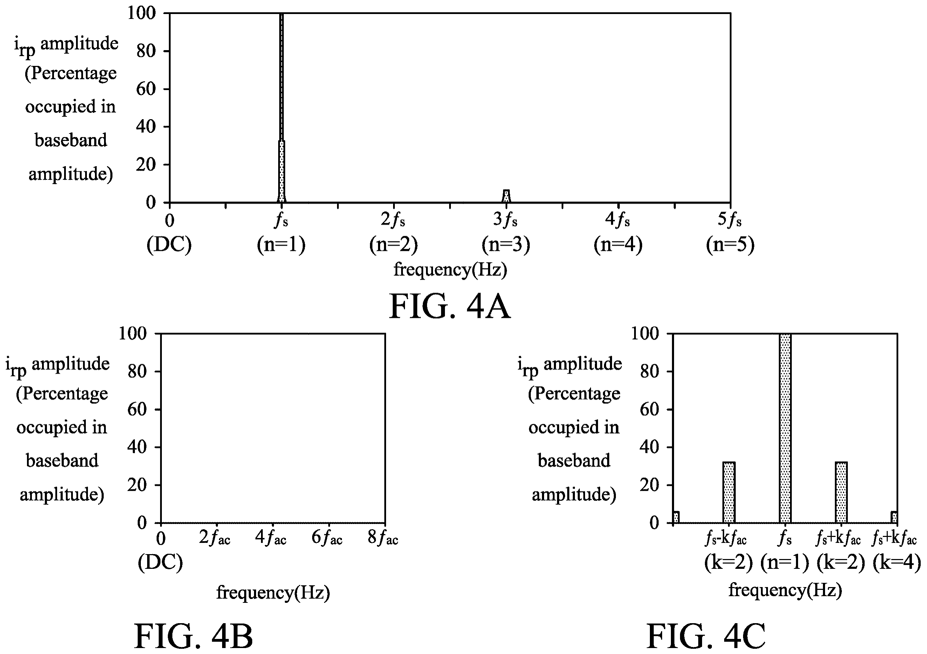

FIG. 4A a spectrum diagram of the resonant current $i_{rp}$ in the resonant circuit 102 of FIG. 1 based on the switching frequency $f_s$ in accordance with some embodiments of the present invention. As shown in FIG. 4A, since the capacitor $C_{rp}$ will block the DC component in the resonant current $i_{rp}$, the amplitude of the resonant current $i_{rp}$ at frequency 0 (that is, the DC) is 0. The resonant current $i_{rp}$ has the maximal amplitude at the switching frequency $f_s$ (n=1). The resonant current $i_{rp}$ has the minimal amplitude at 3 times the switching frequency $3f_s$ (n=3).

FIG. 4B a spectrum diagram of the resonant current $i_{rp}$ in the resonant circuit 102 of FIG. 1 based on the mains frequency $f_{ac}$ in accordance with some embodiments of the present invention. As shown in FIG. 4B, since the capacitor $C_{rp}$ will block the DC component and the low frequency component in the resonant current $i_{rp}$, the amplitude of the resonant current $i_{rp}$ at frequency 0 (that is, the DC), 2 times the mains frequency $2f_{ac}$ of the AC power source $V_{ac}$, 4 times the mains frequency $4f_{ac}$ of the AC power source $V_{ac}$, 6 times the mains frequency $6f_{ac}$ of the AC power source $V_{ac}$, and 8 times the mains frequency $8f_{ac}$ of the AC power source $V_{ac}$ is all 0.

FIG. 4C a spectrum diagram of the resonant current $i_{rp}$ in the resonant circuit 102 of FIG. 1 based on the switching frequency $f_s$ and the sideband frequency $f_s \pm kf_{ac}$ in accordance with some embodiments of the present invention. As shown in FIG. 4C, the resonant current $i_{rp}$ has the maximal amplitude at the switching frequency $f_s$ (n=1). The resonant current $i_{rp}$ has the same amplitude at the frequency $(n \cdot f_s + k \cdot f_{ac})$ and the frequency $(n \cdot f_s - k \cdot f_{ac})$.

Please refer to FIG. 3A, FIG. 3B, FIG. 4A, and FIG. 4B at the same time. Power is equal to voltage multiplied by current. Since the capacitor $C_{rp}$ will block the DC component and the low frequency component in the resonant current $i_{rp}$, the voltage $V_c$ in equation 3 and the voltage $v_{rp,k}(t)$ in equation 4 do not perform work. Please refer to FIG. 3C and FIG. 4C at the same time. The main work components of the resonant tank voltage $V_{rp}$ include the resonant tank baseband voltage $V_{rp1}$ that does work at the switching frequency $f_s$ and the low-order sideband frequency resonant voltage that does work at the frequency $f_s \pm kf_{ac}$), that is, the voltage $v_{rp1,sbk}$.

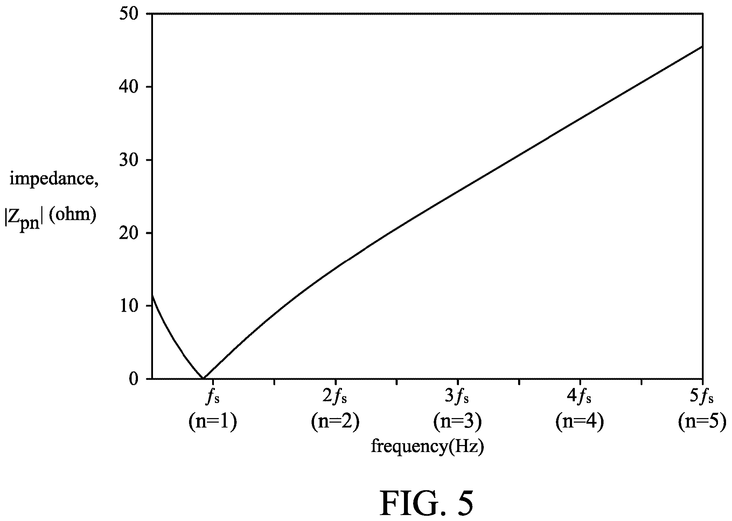

FIG. 5 is a diagram of a relationship between a resonant tank impedance $|Z_{pn}|$ and both the switching frequency $f_s$ and its harmonic frequency in the resonant circuit 102 of FIG. 1 in accordance with some embodiments of the present invention. As shown in FIG. 5, the resonant tank impedance $|Z_{pn}|$ has a minimum value near the switching frequency $f_s$, which is the resonant frequency or near the resonant frequency. Since the impedance value of the resonant tank impedance $|Z_{pn}|$ at 3 times the switching frequency $3f_s$ and at 5 times the switching frequency $5f_s$ is much larger than the baseband impedance $Z_{p1}$, and the impedance value of the resonant tank impedance $|Z_{pn}|$ at the low-order sideband frequency $(f_s \pm k \cdot f_{ac})$ will be close to the baseband impedance $Z_{p1}$, the main work components of the resonant tank voltage $V_{rp}$ include the resonant tank baseband voltage $V_{rp1}$ that does work at the switching frequency $f_s$ and the low-order sideband resonant voltage $v_{rp1,sbk}$ that does work at the frequency $(f_s \pm k \cdot f_{ac})$.

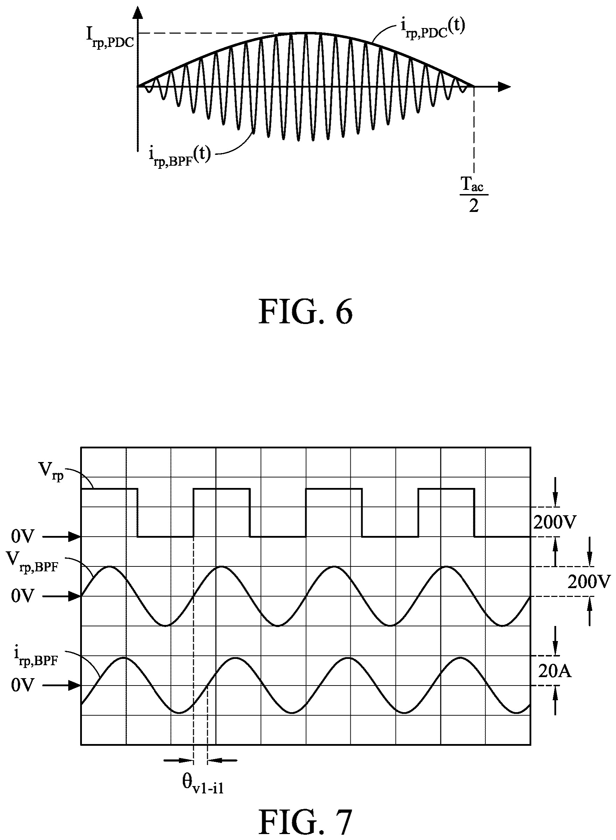

FIG. 6 is a waveform diagram of a first baseband current $i_{rp,BPF}(t)$, a low frequency current $i_{rp,PDC}(t)$, and a baseband current peak value $I_{rp,PDC}$ in the resonant circuit 102 of FIG. 1 in accordance with some embodiments of the present invention. FIG. 6 first discloses the waveform diagram of the first baseband current $i_{rp,BPF}(t)$ generated after filtering by the bandpass filter 108 in the period $\frac{T_{ac}}{2}$. The AC period $T_{ac}$ is the reciprocal of the frequency $f_{ac}$ of the AC power source $V_{ac}$, which can be, for example, the reciprocal of the mains frequency 60Hz. Next, the peak detection circuit 112 performs peak detection on the first baseband current $i_{rp,BPF}(t)$ to generate the low frequency current $i_{rp,PDC}(t)$ in FIG. 6. The baseband current peak value $I_{rp,PDC}$ is the maximal amplitude of the low frequency current $i_{r,PDC}(t)$.

In detail, the first baseband current $i_{rp,BPF}(t)$ can be expressed by the following equation 8.

$$i_{rp,BPF}(t) = i_{rp1}(t) + \sum_{k=even}^{\infty} i_{rp1,sbk}(t) \dots \text{equation 8.}$$

In equation 8,

$$i_{rp1}(t) = I_{rp1} \sin(2\pi f_s + \theta_{i1}) \quad \text{(equation 9)}$$

is provided. $I_{rp1}$ is the baseband current peak value, and $\theta_{i1}$ is the phase of the baseband current.

In equation 8,

$$i_{rp1,sbk}(t) = I_{rp1,sbk} \sin[(f_s \pm kf_{ac})2\pi t + \theta_{i1}] \quad \text{(equation 10)}$$

is provided. $I_{rp1,sbk}$ is the current peak value of k times the sideband near the baseband (i.e., the switching frequency $f_s$).

In detail, the low frequency current $i_{rp,PDC}(t)$ can be expressed by the following equation 11.

$$i_{rp,PDC}(t) = I_{rp1} + \sum_{k=even}^{\infty} \frac{-2}{k^2-1} \cos(2k\pi f_{ac}t)...\text{equation 11}.$$

Using the Taylor series expansion of the arctangent function, equation 11 can be written as the following equation 12.

$$i_{rp,PDC}(t) = I_{rp1} + (\frac{\pi}{2} - 1)I_{rp1} \cos(2k\pi f_{ac}t)...\text{equation 12}.$$

When cos($2k\pi f_{ac}t$)= 1 is provided, the peak value of $i_{rp,PDC}(t)$ can be obtained. That is, the baseband current peak value $I_{rp,PDC}$ can be expressed by the following equation 13.

$$I_{rp,PDC} = \frac{3\pi}{2} I_{rp1,sb2}...\text{equation 13}.$$

$I_{rp1,sb2}$ is the peak value of the first sideband frequency ($f_s \pm 2 f_{ac}$) on both sides of the baseband component.

FIG. 7 is a waveform diagram of the resonant tank voltage $V_{rp}$, a baseband voltage $V_{rp,BPF}$, and the first baseband current $i_{rp,BPF}$ in the resonant circuit 102 of FIG. 1 in accordance with some embodiments of the present invention. As shown in FIG. 7, the resonant tank voltage $V_{rp}$ is a square wave signal with an amplitude higher than 200V and a switching period $T_s$. The duty cycle of the resonant tank voltage $V_{rp}$ is 50%. The switching period $T_s$ is the reciprocal of the switching frequency $f_s$. In some embodiments, if the bandpass filter 108 filters the resonant tank voltage $V_{rp}$, a baseband voltage $V_{rp,BPF}$ with an amplitude equal to 200V and a switching period $T_s$ can be obtained. The baseband voltage $V_{rp,BPF}$ is a sine wave signal. FIG. 7 discloses the waveform diagram of the first baseband current $i_{rp,BPF}$ generated after being filtered by the bandpass filter 108. As shown in FIG. 7, the time point when the waveform of the baseband voltage $V_{rp,BPF}$ passes through the voltage 0 point is the same as the time point when the rising edge of the resonant tank voltage $V_{rp}$ occurs. Therefore, the present invention does not need to obtain the baseband voltage $V_{rp,BPF}$ in advance. Instead, the phase detection circuit 110 directly calculates the phase difference $\theta_{v1-i1}$.

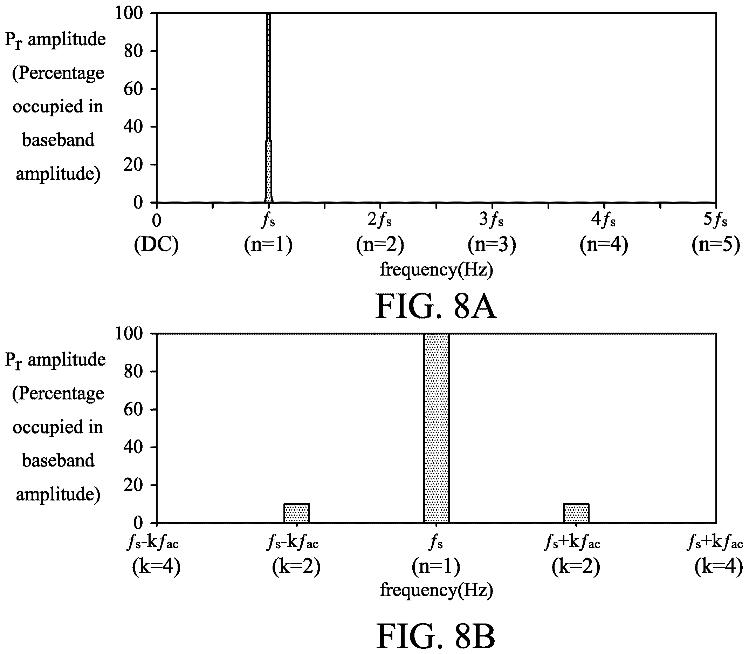

FIG. 8A is spectrum diagram of the input power $P_r$ calculated by a processor 114 based on the switching frequency $f_s$ in accordance with some embodiments of the present invention. As shown in FIG. 8A, the input power $P_r$ has the maximum amplitude at and near the switching frequency $f_s$ (n=1).

FIG. 8B is spectrum diagram of the input power $P_r$ calculated by the processor 114 based on the switching frequency $f_s$ and the sideband frequency $f_s \pm kf_{ac}$ in accordance with some embodiments of the present invention. As shown in FIG. 8B, the input power $P_r$ has the maximal amplitude at the switching frequency $f_s$ (n=1), which is the baseband power. The input power $P_r$ has a sub-maximal amplitude value at the low-order sideband frequency ($f_s \pm kf_{ac}$), which is the maximal sideband power.

In detail, the input power $P_r$ can be expressed by the following equation 14.

$$P_r = P_{r1} + 2P_{r1,sb2} = \frac{11}{18} V_{rp1} I_{rp1} \cos(\theta_{v1} - \theta_{i1})...\text{equation 14}.$$

In equation 14,

$$P_{r1} = \frac{1}{2} V_{rp1} I_{rp1} \cos(\theta_{v1} - \theta_{i1}) \text{ (equation 15)}$$

is provided.

In equation 14,

$$P_{r1,sb2} = \frac{1}{9} P_{r1} \text{ (equation 16)}$$

is provided.

The present invention substitutes equation 13 into equation 14 to obtain equation 1.

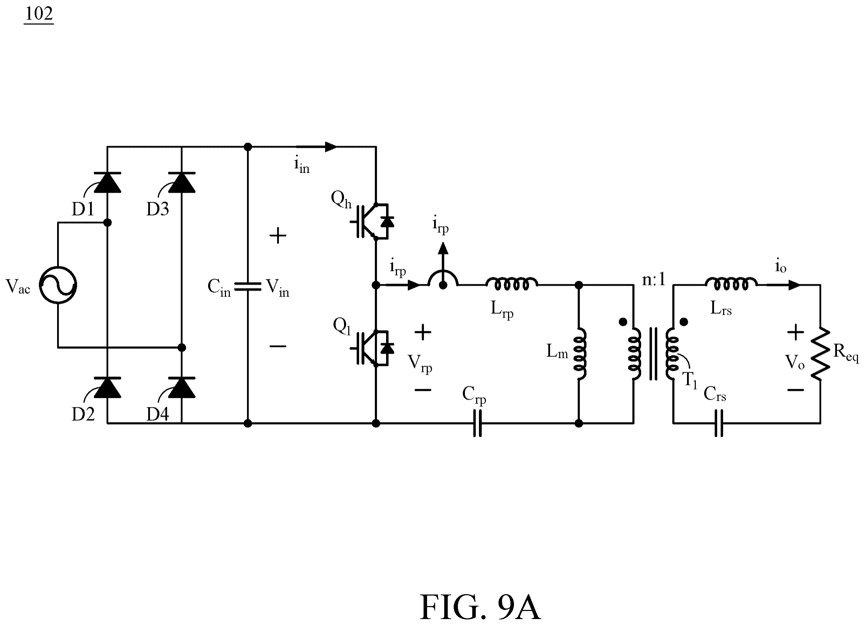

FIG. 9A is a schematic diagram of the resonant circuit 102 in FIG. 1 in accordance with some embodiments of the present invention. In some embodiments of FIG. 9A, the resonant circuit 102 is a wireless power transmission circuit of a pair of series resonant circuits. In some embodiments of FIG. 9A, the resonant circuit 102 includes the AC power source $V_{ac}$, the diode $D_1$, the diode $D_2$, the diode $D_3$, the diode $D_4$, the capacitor $C_{in}$, the transistor $Q_h$, the transistor $Q_l$, the inductor $L_{rp}$, the capacitor $C_{rp}$, and the inductor $L_m$. One end of the AC power source $V_{ac}$ is electrically connected to the first end of the diode $D_1$ and the second end of the diode $D_2$. The other end of the AC power source $V_{ac}$ is electrically connected to the first end of the diode $D_3$ and the second end of the diode $D_4$. The second end of the diode $D_1$ is electrically connected to the second end of the diode $D_3$. The first end of the diode $D_2$ is electrically connected to the first end of the diode $D_4$. The diode $D_1$, the diode $D_2$, the diode $D_3$, and the diode $D_4$ use the physics feature that signals can only pass from their first end to their second end, but cannot pass from their second end to their first end, to perform a rectification operation on the signal output by the AC power source $V_{ac}$ to obtain the input current $i_{in}$ and the input voltage $v_{in}$ generated across the capacitor $C_{in}$. Both ends of the capacitor $C_{in}$ are connected across the second end of the diode $D_3$ and the first end of the diode $D_4$ respectively.

The control end of the transistor $Q_h$ receives the driving signal $G_{oh}$ from the gate driving circuit 106. The first end of the transistor $Q_h$ is electrically connected to the second end of the diode $D_3$. The second end of the transistor $Q_h$ is electrically connected to the first end of the transistor $Q_l$. The control end of the transistor $Q_l$ receives the driving signal $G_{ol}$ from the gate driving circuit 106. The first end of the transistor $Q_l$ is electrically connected to the inductor $L_{rp}$. The second end of the transistor $Q_l$ is electrically connected to the first end of the diode $D_4$ and the capacitor $C_{rp}$. The resonant tank of the resonant circuit 102 includes the inductor $L_{rp}$, the capacitor $C_{rp}$, and the load resistor $R_{eq}$, but the present invention is not limited thereto. The voltage across the first end and the second end of the transistor $Q_l$ is equal to the resonant tank voltage $V_{rp}$. The current flowing from the second end of the transistor $Q_h$ to the inductor $L_{rp}$ is equal to the resonant current $i_{rp}$.

In some embodiments of FIG. 9A, the resonant circuit 102 further includes a transformer $T_1$, an inductor $L_{rs}$, a capacitor $C_{rs}$, and a load resistor $R_{eq}$. The turns ratio between the primary side and the secondary side of the transformer $T_1$ is n:1. The primary side of the transformer $T_1$ is electrically connected between the inductor $L_{rp}$ and the capacitor $C_{rp}$. The secondary side of transformer $T_1$ is electrically connected between the inductor $L_{rs}$ and capacitor $C_{rs}$. The secondary side of the transformer $T_1$ induces an output current $i_o$ based on the resonant current $i_{rp}$ of its primary side. When the output current $i_o$ flows through the load resistor $R_{eq}$, the output voltage $V_o$ is generated. The output voltage $V_o$ is an AC signal.

In some embodiments of FIG. 9A, the output power $P_o$ can be expressed by the following equation 17.

$$P_o = \frac{1}{T}\int_T \ v_o i_o dt = P_r - P_{coil} \ldots \text{equation 17.}$$

In equation 17, $P_r$ can be expressed by equation 1. $P_{coil}$ is the loss between wireless power transmission coils.

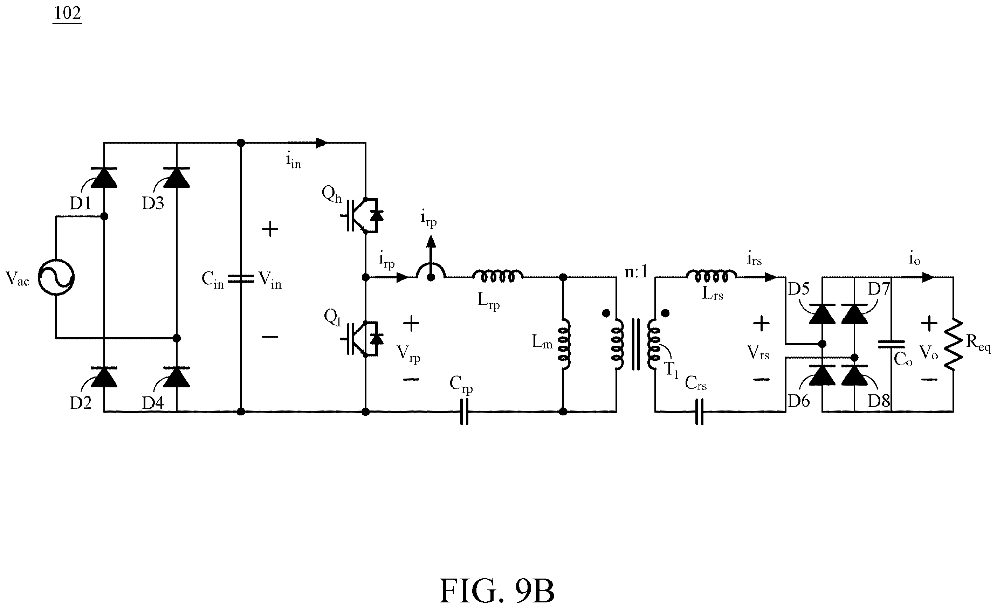

FIG. 9B is a schematic diagram of the resonant circuit 102 in FIG. 1 in accordance with some embodiments of the present invention. The main difference between FIG. 9B and FIG. 9A is that, in FIG. 9B, in addition to the transformer $T_1$, the inductor $L_{rs}$, the capacitor $C_{rs}$, and the load resistor $R_{eq}$, the resonant circuit 102 also includes a diode $D_5$, a diode $D_6$, a diode $D_7$, and a diode $D_8$. The diode $D_5$, the diode $D_6$, the diode $D_7$, and the diode $D_8$ form a full-wave rectifier circuit to convert the AC voltage $V_{rs}$ between the secondary side inductance $L_{rs}$ and capacitor $C_{rs}$ of the transformer $T_1$ into DC output voltage $V_o$.

In some embodiments of FIG. 9B, the output power $P_o$ can be expressed by the following equation 18.

$$P_o = \frac{1}{T}\int_T \ v_o i_o dt = P_r - P_{coil} - P_{diode} \ldots \text{equation 18.}$$

In equation 18, $P_r$ can be expressed by equation 1. $P_{coil}$ is the loss between wireless power transmission coils. $P_{diode}$ is the loss caused by diode full-wave rectification.

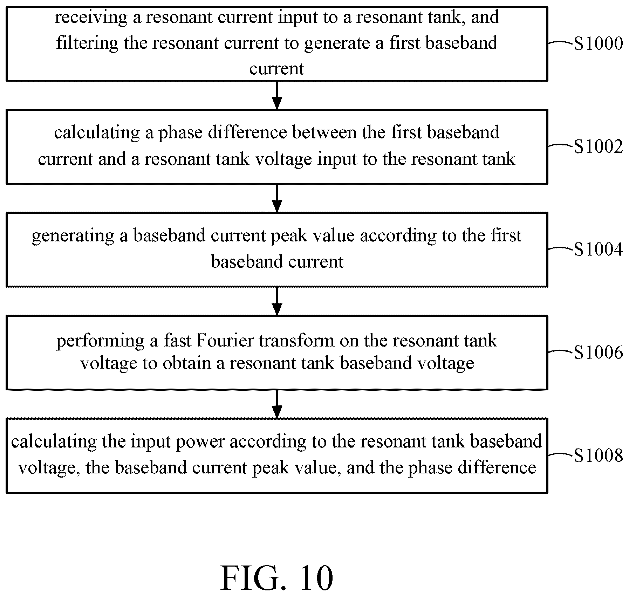

FIG. 10 is a flow chart of a method to estimate input power input to a resonant tank in a resonant circuit in accordance with some embodiments of the present invention. As shown in FIG. 10, the method to estimate input power input to a resonant tank in a resonant circuit includes the following steps. A resonant current input to the resonant tank is received, and the resonant current is filtered to generate a first baseband current (step S1000). A phase difference between the first baseband current and a resonant tank voltage input to the resonant tank is calculated (step S1002). A baseband current peak value is generated according to the first baseband current (step S1004). A fast Fourier transform is performed on the resonant tank voltage to obtain a resonant tank baseband voltage (step S1006). The input power is calculated according to the resonant tank baseband voltage, the baseband current peak value, and the phase difference (step S1008).

In some embodiments, step S1000 may be performed, for example, by the bandpass filter 108 in FIG. 1. Step S1002 may be performed, for example, by the phase detection circuit 110 in FIG. 1. Step S1004 may be performed, for example, by the peak detection circuit 112 in FIG. 1. Steps S1006 and S1008 may be performed, for example, by the processor 114 in FIG. 1.

In some embodiments, step S1008 includes calculating the input power according to the following equation. The equation is $P_r = \frac{11}{9\pi} V_{rp1} I_{rp,PDC} \cos(\theta_{v1} - \theta_{i1})$. $P_r$ is the input power, $V_{rp1}$ is the resonant tank baseband voltage, $I_{rp,PDC}$ is the baseband current peak value, and $\theta_{v1} - \theta_{i1}$ is the phase difference between the first baseband current $i_{rp,BPF}$ and the rising edge of the resonant tank voltage $V_{rp}$.

In some embodiments, the method to estimate input power input to the resonant tank in the resonant circuit further includes the following steps.

Reference input power is received, and the reference input power and the input power are subtracted to obtain the power difference. The input power is adjusted according to the power difference to obtain the total input power. The frequency of a pulse signal is adjusted according to the total input power, and the pulse signal is output. The resonant circuit is driven according to the pulse signal.

While the invention has been described by way of example and in terms of the preferred embodiments, it should be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. An electronic device (100) to calculate input power ($P_r$) input to a resonant tank in a resonant circuit (102), comprising:

   a bandpass filter (108), configured to receive a resonant current ($i_{rp}$) input to the resonant tank, and filter the resonant current to generate a first baseband current ($i_{rp,BPF}$);
   a phase detection circuit (110), electrically connected to the bandpass filter, configured to calculate a phase difference ($\theta_{v1-i1}$) between the first baseband current and a resonant tank voltage ($V_{rp}$) input to the resonant tank;
   a peak detection circuit (112), electrically connected to the bandpass filter, configured to generate a baseband current peak value ($I_{rp,PDC}$) according to the first baseband current; and
   a processor (114), electrically connected the phase detection circuit and the peak detection circuit, configured to perform a fast Fourier transform on the resonant tank voltage to obtain a resonant tank baseband voltage ($V_{rp1}$), wherein the processor is configured to calculate the input power according to the resonant tank baseband voltage, the baseband current peak value, and the phase difference.

2. The electronic device as claimed in claim 1, wherein the processor calculates the input power using the following equation:

$$P_r = \frac{11}{9\pi} V_{rp1} I_{rp,PDC} \cos(\theta_{v1} - \theta_{i1});$$

   wherein $P_r$ is the input power, $V_{rp1}$ is the resonant tank baseband voltage, $I_{rp,PDC}$ is the baseband current peak value, and $\theta_{v1} - \theta_{i1}$ is the phase difference between the first baseband current and a rising edge of the resonant tank voltage.

3. The electronic device as claimed in claim 1 or 2, further comprising:

   a subtractor (116), electrically connected to the processor, configured to receive reference input power ($P_r^*$) and the input power from the processor, and subtract the reference input power and the input power to obtain a power difference.

4. The electronic device as claimed in claim 3, further comprising:
   a power regulator (118), electrically connected to the subtractor, configured to adjust the input power according to the power difference to obtain a total input power.

5. The electronic device as claimed in claim 4, further comprising:
   a pulse frequency modulation circuit (120), electrically connected to the power regulator, configured to adjust a frequency of a pulse signal ($G_h$, $G_l$) according to the total input power, and output the pulse signal.

6. The electronic device as claimed in claim 5, further comprising:
   a gate driving circuit (106), electrically connected to the pulse frequency modulation circuit, configured to drive the resonant circuit according to the pulse signal.

7. The electronic device as claimed in one of the preceding claims, wherein the input power comprises baseband power and maximum sideband power.

8. The electronic device as claimed in claim 1, wherein the resonant circuit is an inductor-inductor-capacitor (LLC) circuit, or a resonant circuit for wireless energy transmission, or a resonant circuit of an induction cooker.

9. A method to estimate input power ($P_r$) input to a resonant tank in a resonant circuit (102), comprising:

receiving a resonant current ($i_{rp}$) input to the resonant tank, and filtering the resonant current to generate a first baseband current ($i_{rp,BPF}$) (S1000);
calculating a phase difference ($\theta_{v1-i1}$) between the first baseband current and a resonant tank voltage ($V_{rp}$) input to the resonant tank (S1002);
generating a baseband current peak value ($I_{rp,PDC}$) according to the first baseband current (S1004);
performing a fast Fourier transform on the resonant tank voltage to obtain a resonant tank baseband voltage ($V_{rp1}$) (S1006); and
calculating the input power according to the resonant tank baseband voltage, the baseband current peak value, and the phase difference (S1008).

10. The method as claimed in claim 9, wherein the step of calculating the input power according to the resonant tank baseband voltage, the baseband current peak value, and the phase difference comprises:

calculating the input power using an equation; wherein the equation is:

$$P_r = \frac{11}{9\pi} V_{rp1} I_{rp,PDC} \cos(\theta_{v1} - \theta_{i1});$$

wherein $P_r$ is the input power, $V_{rp1}$ is the resonant tank baseband voltage, $I_{rp,PDC}$ is the baseband current peak value, and $\theta_{v1} - \theta_{i1}$ is the phase difference between the first baseband current and the rising edge of the resonant tank voltage.

11. The method as claimed in claim 9 or 10, further comprising:

receiving reference input power ($P_r^*$), and subtracting the reference input power and the input power to obtain the power difference;
adjusting the input power according to the power difference to obtain the total input power;
adjusting the frequency of a pulse signal ($G_h$, $G_l$) according to the total input power, and outputting the pulse signal; and
driving the resonant circuit according to the pulse signal.

<u>100</u>

FIG. 1

$V_{in}(t)$

$V_{rp}(t)$

$i_{rp}(t)$

$DT_s$

$T_{ac}$

FIG. 2

EP 4 733 779 A1

FIG. 3A

FIG. 3B

FIG. 3C

FIG. 4A

FIG. 4B

FIG. 4C

FIG. 5

FIG. 6

FIG. 7

FIG. 8A

FIG. 8B

FIG. 9A

102

FIG. 9B

EP 4 733 779 A1

```
┌─────────────────────────────────────────────────────┐
│ receiving a resonant current input to a resonant     │
│ tank, and filtering the resonant current to generate │ ──S1000
│ a first baseband current                             │
└─────────────────────────────────────────────────────┘
                         │
                         ▼
┌─────────────────────────────────────────────────────┐
│ calculating a phase difference between the first     │
│ baseband current and a resonant tank voltage input   │ ──S1002
│ to the resonant tank                                 │
└─────────────────────────────────────────────────────┘
                         │
                         ▼
┌─────────────────────────────────────────────────────┐
│ generating a baseband current peak value according   │
│ to the first baseband current                        │ ──S1004
└─────────────────────────────────────────────────────┘
                         │
                         ▼
┌─────────────────────────────────────────────────────┐
│ performing a fast Fourier transform on the resonant  │
│ tank voltage to obtain a resonant tank baseband      │ ──S1006
│ voltage                                              │
└─────────────────────────────────────────────────────┘
                         │
                         ▼
┌─────────────────────────────────────────────────────┐
│ calculating the input power according to the         │
│ resonant tank baseband voltage, the baseband current │ ──S1008
│ peak value, and the phase difference                 │
└─────────────────────────────────────────────────────┘
```

FIG. 10

Europäisches
Patentamt

European
Patent Office

Office européen
des brevets

# EUROPEAN SEARCH REPORT

**Application Number**

EP 25 20 2353

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 4 206 702 A1 (DELTA ELECTRONICS INC [TW]) 5 July 2023 (2023-07-05) | 1,3-6,8,9,11 | INV. G01R21/00 |
| A | * paragraphs [0002] - [0045]; claims 1-7; figures 1-5 * | 2,7,10 | H02J50/12 H05B6/06 H05B6/12 |
| Y | CN 114 424 674 B (YILLI HOUSEHOLD APPLIANCE SHARE COMPANY) 22 December 2023 (2023-12-22) | 1,3-6,8,9,11 | |
| A | * paragraphs [0048] - [0149]; claims 1-17; figures 1-7 * | 2,7,10 | |
| A | US 5 319 174 A (OMORI HIDEKI [JP] ET AL) 7 June 1994 (1994-06-07) * columns 3-7; claims 1-3; figures 1-10 * | 1-11 | |

**TECHNICAL FIELDS SEARCHED (IPC)**

G01R
H02J
H05B

The present search report has been drawn up for all claims

| Place of search | Date of completion of the search | Examiner |
|---|---|---|
| Munich | 24 February 2026 | Bilzer, Claus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 20 2353

This annex lists the patent family members relating to the patent documents cited in the above-mentioned European search report.
The members are as contained in the European Patent Office EDP file on
The European Patent Office is in no way liable for these particulars which are merely given for the purpose of information.

24-02-2026

| Patent document cited in search report | | Publication date | Patent family member(s) | | Publication date |
|---|---|---|---|---|---|
| EP 4206702 | A1 | 05-07-2023 | CN | 116430111 A | 14-07-2023 |
| | | | EP | 4206702 A1 | 05-07-2023 |
| | | | ES | 2984822 T3 | 31-10-2024 |
| | | | US | 2023213591 A1 | 06-07-2023 |
| CN 114424674 | B | 22-12-2023 | NONE | | |
| US 5319174 | A | 07-06-1994 | AU | 620261 B2 | 13-02-1992 |
| | | | CA | 2030351 A1 | 08-12-1991 |
| | | | DE | 69015623 T2 | 11-05-1995 |
| | | | EP | 0460279 A2 | 11-12-1991 |
| | | | JP | H0443591 A | 13-02-1992 |
| | | | US | 5319174 A | 07-06-1994 |

EPO FORM P0459

For more details about this annex : see Official Journal of the European Patent Office, No. 12/82

**REFERENCES CITED IN THE DESCRIPTION**

**Patent documents cited in the description**

- CN 202411491144